Europäisches Patentamt

European Patent Office

Office européen des brevets

(19)

(11) Publication number:

0 338 298
A2

## (12) EUROPEAN PATENT APPLICATION

(21) Application number: 89105721.8

(51) Int. Cl.⁴: H01L 23/50

(22) Date of filing: 31.03.89

(30) Priority: 31.03.88 JP 78507/88

(43) Date of publication of application:
25.10.89 Bulletin 89/43

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Nakazawa, Tsutomu C-410, Toshiba
Hiyoshi Ryo
4-14-1, Hiyoshi Hon-Cho Kohoku-ku
Yokohama-Shin Kanagawa-ken(JP)
Inventor: Ichikawa, Keiji 1454-4,
Imajuku-Higashi-Cho
Asahi-ku Yokohama-shi
Kanagawa-ken(JP)
Inventor: Ohno, Jun-ichi
1-24-24, Nagata-Higashi Minami-ku
Yokohama-shi Kanagawa-ken(JP)

(74) Representative: Ritter und Edler von Fischern,
Bernhard,Dipl.-Ing. et al
HOFFMANN - EITLE & PARTNER
Arabellastrasse 4
D-8000 München 81(DE)

(54) Semiconductor device having a lead frame and manufacturing method therefor.

(57) This invention relates to an improvement in the lead frame of a semiconductor device. A semiconductor device of this invention comprises a semiconductor die (1), a die pad (2) having a required thickness for mounting the semiconductor die (1), leads (3) for connecting elements in the semiconductor die (1) and the external, a molding compound (5) for sealing the semiconductor die (1), the die pad (2) and inner lead portions (31) constituting a portion of said leads (3), and bond wires (4) for connecting the semiconductor die (1) and one end of the inner lead portions (31), wherein upper and lower peripheral edges (2a) of the die pad (2) are formed arcuate in cross section. In a method of manufacturing a semiconductor device according to this invention, patterning of resist is implemented so that only the peripheral portion of the die pad is exposed to apply etching only to the exposed portion to process it so as to have arcuate cross section.

FIG. 1

# SEMICONDUCTOR DEVICE AND METHOD OF MANUFACTURING THE SAME

## BACKGROUND OF THE INVENTION

### Field of the Invention

This invention relates to a semiconductor device and a method of manufacturing the same, and more particularly to the structure of a lead frame in a semiconductor device and a method of processing such a lead frame.

### Prior Art

Most typical semiconductor devices being mass-produced at present includes a semiconductor die, a die pad for mounting the semiconductor die thereon, leads for making an electrical connection with the external, bond wires for connecting these leads and the semiconductor die, and molding compound for sealing them. Leads are obtained by cutting predetermined portions of the lead frame. For the method of processing a lead frame, the etching system and the pressing system are known. The etching system is a method comprising the steps of rinsing a sheet material or a coil material used as the material of a lead frame, coating a resist thereon and drying it, carrying out printing and development of a pattern, implementing etching to remove exposed portions, and providing a lead frame having a desired pattern. On the other hand, the pressing method is a method to implement mechanical punching so that a desired pattern is provided.

### Problems to be solved by the Invention

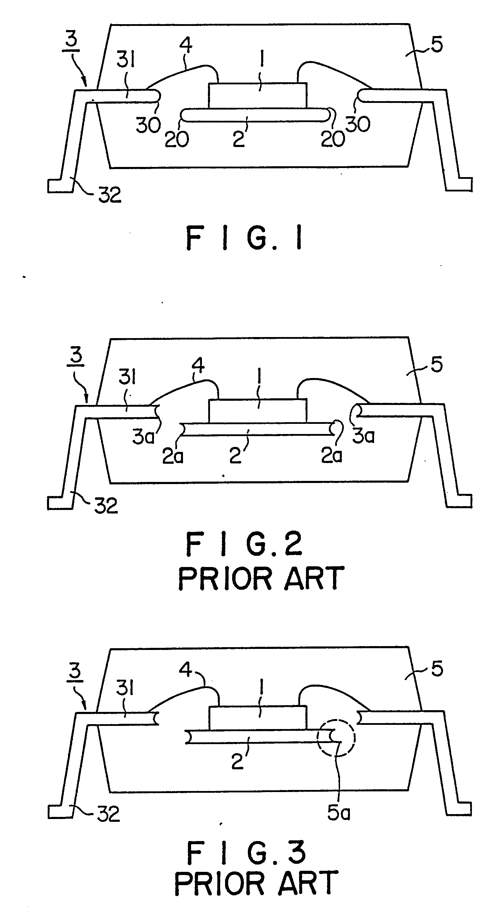

The problem with the conventional semiconductor device was that cracks occur in the molding compound depending upon an environment where they are used. Such a problem is pointed out in I. Fukuzawa et al. "MOISTURE RESISTANCE DEGRADATION OF PLASTIC LSIs REFLOW SOLDERING" (IEEE·IRPS Vol. 9/85 p. 192 (1985)). This literature shows that when heat processing at the time of mounting (FIG. 1b in the literature) is applied to moisture absorbed into the molding compound of the semiconductor device (FIG. 2a in the literature), cracks occur in the molding compound by the pressure when moisture is vaporized (FIG. 2b in the literature). The stress at this time can be expressed by the die size or the die pad size, and the kind and the thickness of the resin or molding compound (FIG. 3 in the literature). It is commonly considered that whether or not crack may occur can be judged by the following formula for judgement:

$$\sigma max = 6k \, (a^2/t^2)P \qquad (1),$$

where $\sigma max$ is a maximum bending stress (Kg/mm$^2$), a is a size (mm) of die or die pad, t is a resin thickness (mm), P is a vapor pressure, and k is a constant.

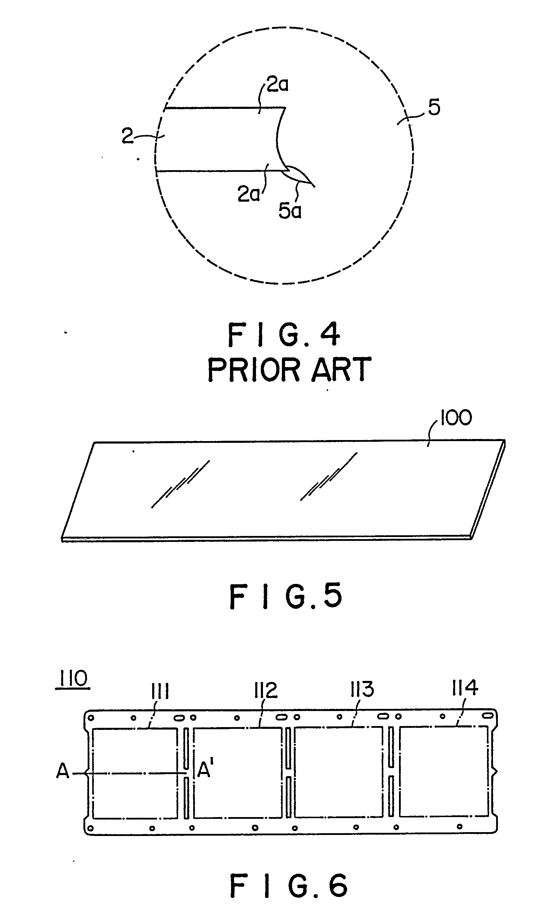

When the left side of this formula is larger than the right side thereof, this formula shows the safety region where no crack occurs,

when the left side of this formula is smaller than the right side thereof, this formula shows the dangerous region where any crack occurs, and

when the left side of this formula is equal to the right side thereof, this formula shows the border or boundary line therebetween (FIG. 5 in the literature).

However, even in semiconductor devices which satisfy the condition of the safety region in the above-described formula for judgement, occurrence of crack is perceptible, resulting in the large problem that yield of product is lowered.

In addition, in the case of the pressing system, projected portions called "sagging" are formed along the punching direction.

## SUMMARY OF THE INVENTION

Therefore, an object of this invention is to provide a semiconductor device in which no crack occurs in the molding compound and a method of manufacturing such a semiconductor device.

To achieve this object, this invention provides a semiconductor device comprising a semiconductor die; a die pad, having a required thickness, for mounting the semiconductor die thereon; leads for connecting elements in the semiconductor die and the external; bond wires for connecting the semiconductor die and the leads, and a molding compound for sealing them, wherein upper and lower peripheral edges of the die pad and upper and lower edges of the connection ends to the bonding wires of the leads are formed arcuate in cross section.

Further, in accordance with a method of manufacturing the above-described semiconductor device according to this invention, patterning of resist is implemented so that only the peripheral portion of the die pad and the connection ends of the leads are exposed to apply etching only to the exposed portions, thus to process the peripheral portion and the connection ends so that they are arcuate in cross section.

Operation

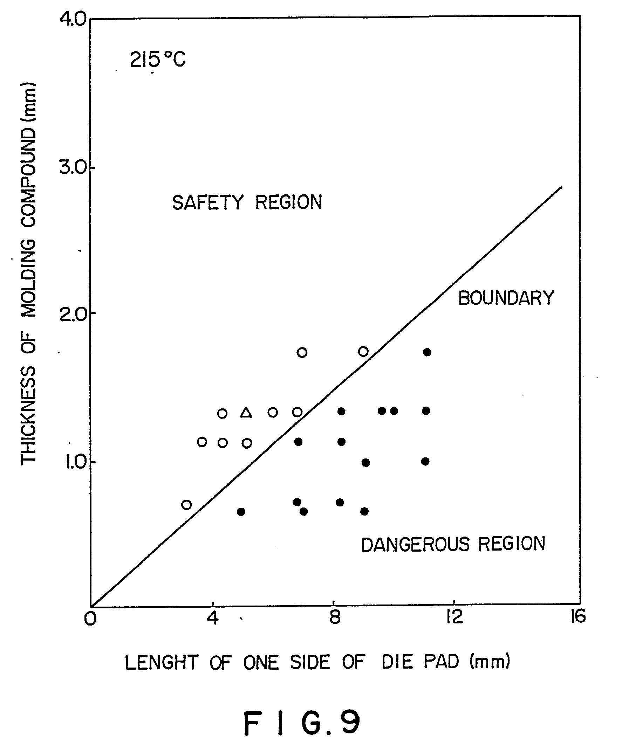

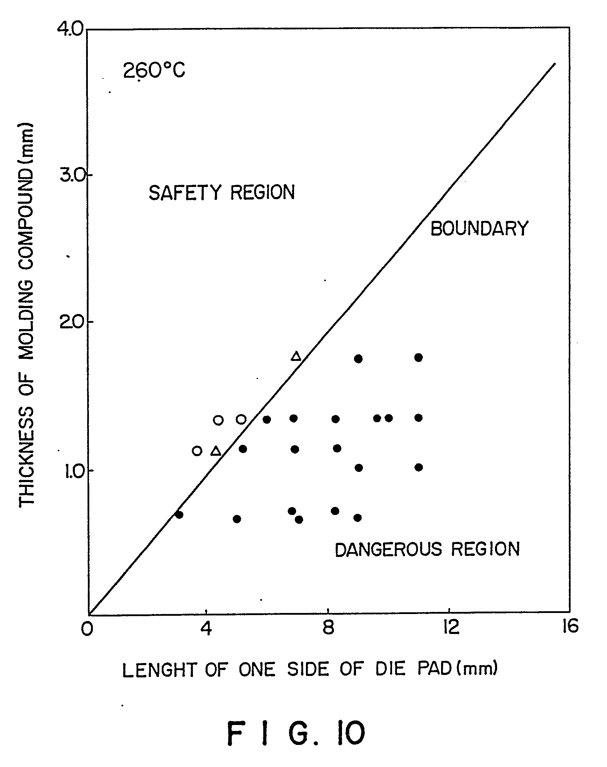

FIGS. 9 and 10 are graphs showing the results of the crack occurrence test of the conventional semiconductor device, respectively. In each graph, abscissa represents the length of one side of a die pad of a semiconductor device used for test and ordinate represents the thickness of a molding compound of the same device. Plots on these graphs show whether or not crack occurs when a predetermined temperature is applied to semiconductor devices having numeric values (the length of one side of the die pad and the thickness of the molding compound) represented by coordinate positions of the plots. Here, black circular marks show that cracks have occurred in all of the 10 samples, and white circular marks show that no crack has occurred in any one of the 10 samples. In addition, triangular marks show that crack has occurred in a portion (ordinarily, one to two) of the 10 samples. FIG. 9 shows the results when a temperature of 215°C is applied for two minutes as a predetermined temperature, and FIG. 10 shows the results when a temperature of 260°C is applied for two minutes as a predetermined temperature.

In accordance with the above-described judgement formula (1), the safety region and the dangerous region can be defined with the border line being as a boundary as shown by respective graphs, and it can be said that there is theoretically no occurrence of crack in the semiconductor device which satisfies the condition of the safety region. However, actually, in the area represented by triangular plots in the graphs, cracks have occurred. The inventor of this application has found out that such an occurrence of crack in the safety region results from the fact that the peripheral portion of the die pad and the front end portion of the inner lead portion include sharp-edged portions, and has succeeded in suppressing occurrence of crack in the safety region by implementing the processing for smoothing the shape to such sharp-edged portions.

## BRIEF DESCRIPTION OF THE DRAWINGS

In the accompanying drawings:

FIG. 1 is a cross sectional view of a semiconductor device according to an embodiment of this invention,

FIG. 2 is a cross sectional view of a conventional semiconductor device,

FIG. 3 is a cross sectional view showing occurrence of crack in the conventional semiconductor device,

FIG. 4 is an enlarged view of crack which has occurred,

FIG. 5 is a perspective view showing a material for preparing the lead frame,

FIG. 6 is a top view of a typical lead frame,

FIG. 7 is a view showing the sequence for processing the lead frame according to this invention,

FIG. 8 is a flowchart showing the steps for processing the lead frame according to this invention, and

FIGS. 9 and 10 are graphs showing the results of the crack occurrence test of the conventional semiconductor device.

## DESCRIPTION OF THE PREFERRED EMBODIMENT

Device of this Invention

This invention will be described in accordance with an embodiment shown. FIG. 1 is a cross sectional view of a semiconductor device according to an embodiment of this invention. The feature of this device becomes apparent by making a comparison with the cross sectional view of a conventional device shown in FIG. 2. These devices both include a semiconductor die 1, a die pad, having a predetermined thickness, for mounting the semiconductor die thereon, and leads 3 for connecting elements in the semiconductor die and the external. These leads 3 are electrically connected to the semiconductor die 1 by means of bond wires 4. In addition, the inner lead portions 31 constituting a portion of the leads 3 are sealed by the molding compound 5, so only the outer lead portions 32 are exposed to the external of the molding compound 5.

The conventional device. shown in FIG. 2 is characterized in that sharp-edged portions 2a are formed at the upper and lower edges of the peripheral portions of the die pad 2, and that sharp-edged portions 3a are formed at the upper and lower edges of the connection ends of the inner lead portions 31. These sharp-edged portions are naturally produced at the process for manufacturing the lead frame. However, if such a sharp-edged portion exists, crack 5a extends as shown in FIG. 3 from that sharp-edged portion when heat is applied at the time of mounting. FIG. 4 is a view showing the appearance of crack which has occurred when a temperature of 215° C is applied for two minutes to the conventional device in which the length of one side of the die pad is 5 mm and the thickness of the molding compound is 1.3 mm. This figure corresponds to the enlarged view of the portions indicated by broken lines in FIG. 3. The inventor of this application has recognized that the crack 5a has been caused by the sharp-edged portion 2a. Namely, it is commonly considered that the internal stress concentrates on the sharp-edged portion, whereby crack may be caused. The inventor of this application has confirmed that there is a correlative relationship between the formation direction of the sharp-edged portion and the direction of crack which takes place. In view of this, as shown in FIG. 1, there was employed a scheme to form portions 20 and 30 arcuate in cross section at the portion where the sharp-edged portions have been conventionally present. By changing the sharp-edged portion so that it is formed as an arcuate portion as stated above, occurrence of crack which has conventionally appeared in the safety region can be completely suppressed.

Advantages with the Embodiment

The experimental results obtained by measuring the crack occurrence rates of 50 conventional devices and 50 devices of this invention as being subjected to the same temperature condition are shown below.

| Temperature | Room Temperature | 215° C | 240° C | 260° C |
|---|---|---|---|---|
| Conventional Device | 0/50 | 24/50 | 42/50 | 50/50 |
| Device of this Invention | 0/50 | 0/50 | 0/50 | 0/50 |

The above Table shows failure occurrence rate of how many samples that crack has occurred of 50 ones are when devices are subjected to respective predetermined temperatures for two minutes. The judgement as to whether crack has occurred was conducted by observation of the cross section of each sample. It has been seen from the above Table that the occurrence rate of crack of the device of this invention is extremely lower than that of the conventional device.

Generally, semiconductor devices are subjected to the heating condition, e.g., vapor phase soldering, infrared heating, solder dipping, etc. at the time of mounting. The device of this invention can exhibit sufficient heat resisting property with respect to the heating at the time of mounting.

Manufacturing Method of this Invention

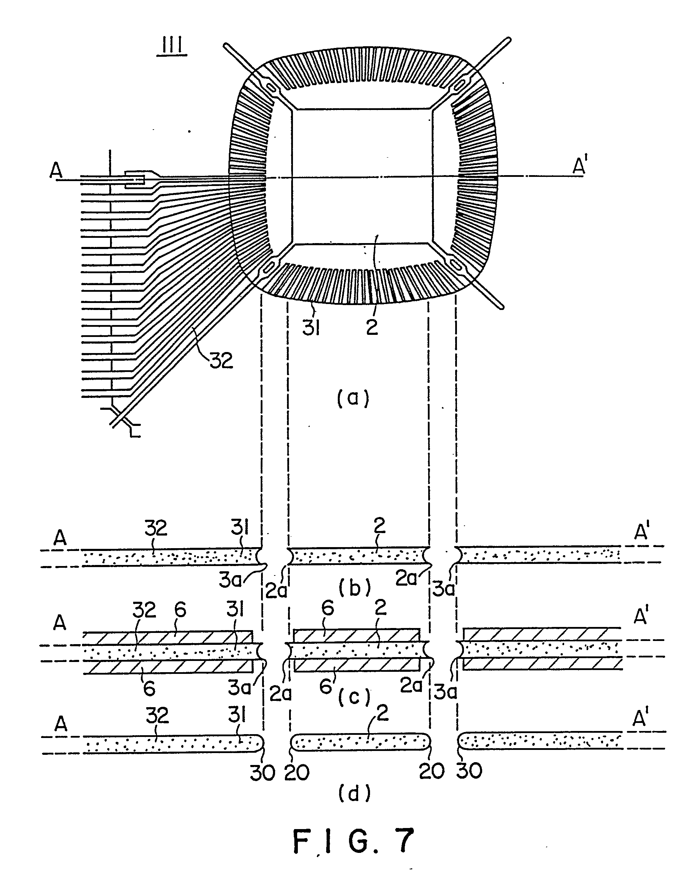

An embodiment of a method of manufacturing a semiconductor device having a structure as shown in FIG. 1 will be now described. Generally, the lead frame is obtained by processing a material 100 of a sheet material or a coil material, etc. as shown in FIG. 5 so that it has a predetermined pattern. In FIG. 6, the lead frame 110 to which pattern processing has been already applied is shown. This lead frame 110 has unit regions 111 to 114 indicated by single dotted lines in the figure, each unit region having the same pattern. FIG. 7a is a plan view showing the detail of the unit region 111 (with a portion thereof being omitted), and FIGS. 7b to 7d are cross sectional views of FIG. 7a, respectively.

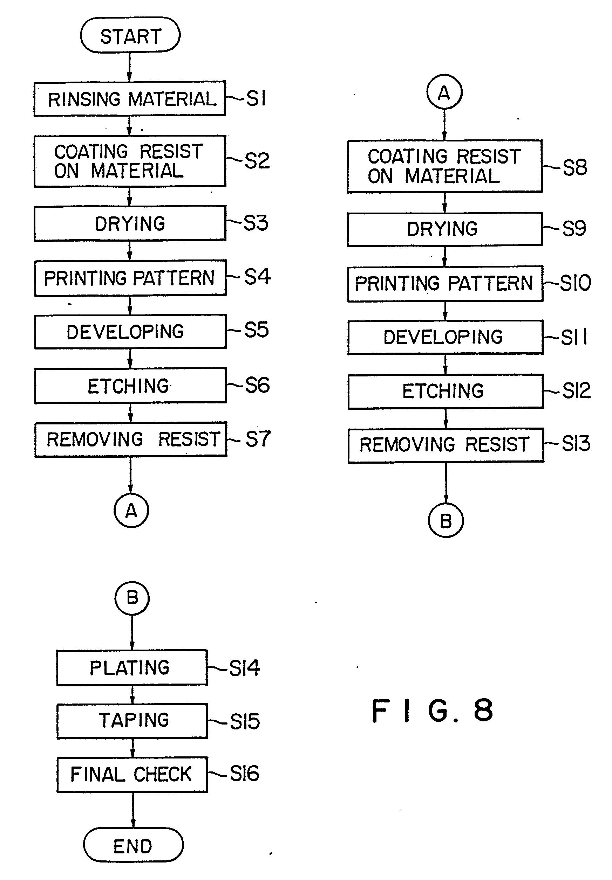

FIG. 8 is a flowchart of a lead frame manufacturing process of a method of manufacturing a semiconductor device according to this invention. First, material 100 is rinsed (step S1) to coat resist thereon and to dry it (steps S2 and S3). Then, printing of pattern is applied thereto (step S4) to conduct development (step S5). In this way, pattern is transferred onto the resist formed on the material 100. Subsequently, etching is implemented with the remaining resist being as a mask (step S6) to remove the resist therefrom (step S7), thus resulting in a lead frame 110 as shown in FIG. 6. The process steps until now are completely the same as those of the conventional processing method. The cross section of the lead frame at this time is shown in FIG. 7b, where sharp-edged portions 2a and 3a exist.

The subsequent process from the step S8 up to the step S13 is peculiar to this invention. By this process, the sharp-edged portions 2a and 3a are removed, resulting portions 20 and 30 arcuate in cross section. First, resist is coated onto the lead frame 110 obtained by the process up to the step S7 to dry it (steps S8 and S9). Then, printing of pattern is implemented (step S10) to carry out development (step S11). This pattern is formed as a pattern such that the resist on the peripheral portions of the die pad of the lead frame and the connection ends of the inner lead portion may be removed. FIG. 7c is a view showing the resist 6 remaining on the lead frame after development. The resist 6 is removed at the peripheral portion of the die pad 2, so that the sharp-edged portions are exposed. While the outer lead portions 32 are completely covered with the resist 6, the resist 6 is removed at one ends of the inner lead portions 31, so that the sharp-edged portions 3a are exposed. Under this condition, etching is implemented (step S12). This may be accomplished, e.g., by immersing the entirety of the lead frame into an etchant of ferric chloride. By this etching, the sharp-edged portions 2a and 3a are removed. When the resist 6 is removed after etching (step S13), a lead frame on which portions 20 and 30 arcuate in cross section are formed as shown in FIG. 7d is provided.

The subsequent process is the same as the conventional one. Namely, plating of the lead frame is carried out (step S14) to conduct taping (step S15) to make a final check (step S16). By constituting a semiconductor device using a lead frame obtained by implementing such processing, a device in which occurrence of crack is reduced to an acceptable level as shown in FIG. 1 is provided.

While it has been disclosed in the above-described embodiment that both the upper and lower edges at the peripheral portion of the die pad and the upper and lower edges of the connection ends to the bond wires of the inner lead portions are formed arcuate in cross section, the advantages with this invention can be obtained by an implementation such that only the upper and lower edges at the peripheral portion of the die pad are formed arcuate in cross section.

## Advantages with the Invention

As stated above, in accordance with this invention, since the upper and lower edges at the peripheral portion of the die pad sealed in the semiconductor device and the upper and lower edges of one ends of the inner lead portions are formed arcuate in cross section, occurrence of crack resulting from the presence of the sharp-edged portion can be satisfactorily suppressed.

## Claims

1. A semiconductor device comprising a semiconductor die (1); a die pad (2), having a required thickness, for mounting said semiconductor die (1) thereon; leads (3) for connecting elements in said semiconductor die (1) and the external; a molding compound (5) for sealing said semiconductor die (1), said die pad (2) and inner lead portions (31) constituting a portion of said leads (3); and bond wires (4) for connecting said semiconductor die (1) and one end of said inner lead portions (31) wherein upper and lower edges (2a) at the peripheral portion of said die pad (2) are formed arcuate in cross section.

2. A semiconductor device as set forth in claim 1, wherein the upper and lower edges (3a) of the connection ends to said bond wires (4) of said inner lead portions (31) are also formed arcuate in cross section.

3. A method of manufacturing a semiconductor device as set forth in claim 1, wherein patterning of resist (6) is implemented so that only the peripheral portion of said die pad (2) is exposed to apply etching only to said exposed portion to process it so as to have arcuate cross section.

4. A method of manufacturing a semiconductor device as set forth in claim 3, wherein patterning of resist (6) is implemented so that the connection ends of said inner lead portions (31) are also exposed.

F I G. I

F I G.2
PRIOR ART

F I G.3
PRIOR ART

F I G . 4
PRIOR ART

F I G . 5

F I G . 6

F I G. 7

START

RINSING MATERIAL — S1

COATING RESIST ON MATERIAL — S2

DRYING — S3

PRINTING PATTERN — S4

DEVELOPING — S5

ETCHING — S6

REMOVING RESIST — S7

A

A

COATING RESIST ON MATERIAL — S8

DRYING — S9

PRINTING PATTERN — S10

DEVELOPING — S11

ETCHING — S12

REMOVING RESIST — S13

B

B

PLATING — S14

TAPING — S15

FINAL CHECK — S16

END

F I G. 8

F I G. 9

F I G. 10